# EUROPEAN PATENT SPECIFICATION

(11) **EP 3 591 643 B1**
(45) Date of publication and mention of the grant of the patent: **14.09.2022**
(21) Application number: 19184266.5
(22) Date of filing: 03.07.2019
(51) Int. Cl.: G06F 1/16

(54) **DISPLAY DEVICE**
ANZEIGEVORRICHTUNG
DISPOSITIF D'AFFICHAGE

(30) Priority: 03.07.2018 KR 20180076894
(43) Date of publication of application: 08.01.2020
(73) Proprietor: LG Display Co., Ltd., SEOUL, 07336 (KR)
(72) Inventor: CHO, SeokHyo, 10845 Paju-si (KR)
(74) Representative: Harden, Henry Simon

(56) References cited:
- EP-A1- 1 713 047
- EP-A1- 3 173 897
- JP-A- 2010 078 684
- JP-B2- 3 243 038

## Description

### BACKGROUND

### Field

The present disclosure relates to a display device, and more particularly, to a rollable display device which is capable of displaying images even in a rolled state.

### Description of the Related Art

As display devices which are used for a monitor of a computer, a television, or a cellular phone, there are an organic light emitting display device (OLED) which is a self-emitting device and a liquid crystal display device (LCD) which requires a separate light source.

An applicable range of the display device is diversified to personal digital assistants as well as monitors of computers and televisions and a display device with a large display area and a reduced volume and weight is being studied.

Further, recently, a rollable display device which is manufactured by forming a display unit and a wiring line on a flexible substrate such as plastic which is a flexible material so as to be capable of displaying images even though the display device is rolled is getting attention as a next generation display device.
EP3173897 describes a display device. The display device includes: a housing; at least one roller configured to be positioned within the housing; a display portion including a display panel and a module cover; and an operating portion configured to be attached to one end of the display portion and to change the display portion's state, wherein the display panel and the module cover are either in a first state where the display panel and the module cover are kept wound around the at least one roller or in a second state where the display panel and the module cover are kept unwound from the at least one roller, in contact with each other, and exposed out of the housing, and wherein the operating portion includes: a motor assembly; a support, one end of which is connected to one end of the display portion and the other end is connected to the motor assembly; a transmission portion, one end of which is connected to the support; and an auxiliary link configured to be attached to the bottom of the housing and connected to the other end of the transmission portion, the auxiliary link including a spring portion inside configured to push the transmission portion.
JP 2010 078684 describes a screen and a pantograph mechanism constituting the screen. A first end and a second end in a pair of arms and are turnably coupled to a base body, and a third end and a fourth end of a pair of arms and are turnably coupled to an auxiliary support body.
EP1713047 describes a display device that includes a display part made of a roll-up sheet-like direct-view display element; a take-up part attached on one end of the display part, the take-up part allowing the display part to be rolled up; a pulling part attached on the other end of the display part, the pulling part allowing the display part to be roll out; and a holding part for holding the display part from behind. The holding part is formed of linkage, which can be stored on the rear surface of the display part when the display part is rolled up, and can be stretched across the rear surface of the display part when the display part is rolled out.

### SUMMARY

An invention is defined in the claims.

An object to be achieved by the present disclosure is to provide a display device which precisely winds or unwinds a display panel by precisely controlling a roller.

Another object to be achieved by the present disclosure is to provide a display device with a simplified structure in which a force from a driving unit and a lifting unit which generates force to wind or unwind the display panel is directly transmitted to a roller and a link without using an intermediate medium.

Still another object to be achieved by the present disclosure is to provide a display device which reduces a volume of a configuration which winds or unwinds a display panel.

Still another object to be achieved by the present disclosure is to provide a display device which increases a degree of freedom of design of a driving unit and a lifting unit by disposing a driving unit and a lifting unit at the outside of a display panel and a roller.

Still another object to be achieved by the present disclosure is to provide a display device which simply adjusts a degree of flatness of at least a part of a display panel which is unwound from a roller.

Objects of the present disclosure are not limited to the above-mentioned objects, and other objects, which are not mentioned above, can be clearly understood by those skilled in the art from the following descriptions.

The display device includes: a display panel, a roller to which a lower edge (e.g. first edge) of the display panel is fixed, a plurality of links (e.g. a link assembly) having one end (e.g. a first end) connected to an upper edge (e.g. second edge opposite the first edge) of the display panel, a driving unit which is configured to rotate the roller, and a lifting unit connected to an other end (e.g. second end) of the link assembly. Accordingly, the force of the driving unit is directly transmitted to the roller and the force of the elastic member is directly transmitted to the link, so that the configuration of the display device may be simplified. The driving unit and the lifting unit may be disposed outside of the roller. The lifting unit may comprise an elastic member. Herein, a 'display unit' and 'display panel' may be used interchangeably.

According to another example of the present disclosure, a rollable display device includes: a roller, a display unit fixed to the roller, a plurality of links which supports the display unit to be flat, a driving unit which rotates the roller, and a lifting unit which applies a force to the plurality of links in which the display unit is wound by the roller which rotates by the driving unit and is unwound by the roller which rotates by the driving unit and the plurality of links which is unfolded by the lifting unit. Accordingly, in order to wind the display unit around the roller, only the driving unit controls the roller, so that it is possible to more precisely control the roller.

Other detailed matters of the exemplary embodiments are included in the detailed description and the drawings.

According to the present disclosure, a display device in which a driving unit directly rotates a roller to precisely control the roller is provided.

According to the present disclosure, in order to wind or unwind the display panel, a driving unit which directly transmits a torque to a roller and a lifting unit which directly transmits a force to a plurality of links are disposed to simplify the configuration of the display device.

According to the present disclosure, a simplified driving unit is disposed to save a space occupied by the driving unit.

According to the present disclosure, the driving unit and the lifting unit are disposed at the outside of the roller, so that the driving unit and the lifting unit are freely repaired and rearranged and a degree of freedom of design of the driving unit and the lifting unit may be increased.

According to the present disclosure, a degree of flatness of the display panel may be simply adjusted by adjusting a modulus of elasticity of an elastic member.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a perspective view of a display device in a fully unwound state according to an embodiment of the present invention;
FIG. 2 is a perspective view of a display device in a fully wound state according to an embodiment of the present invention;
FIG. 3 is an exploded perspective view of a display device according to an exemplary embodiment of the present disclosure;
FIG. 4 is an enlarged perspective view of a display device according to an exemplary embodiment of the present disclosure;
FIG. 5 is a rear view of a display device in a fully wound state according to an exemplary embodiment of the present disclosure;
FIGS. 6A and 6B are schematic views for explaining a driving unit and an elastic member when a display device according to an exemplary embodiment of the present disclosure is unwound;
FIG. 7 is a rear view of a display device in a fully unwound state according to an exemplary embodiment of the present disclosure;
FIGS. 8A and 8B are schematic views for explaining a driving unit and an elastic member when a display device according to an exemplary embodiment of the present disclosure is wound; and
FIG. 9 is an enlarged perspective view for explaining a driving unit, a roller, an elastic member, and a link of a display device according to another exemplary embodiment of the present disclosure.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, exemplary embodiments of the present disclosure will be described in detail with reference to accompanying drawings.

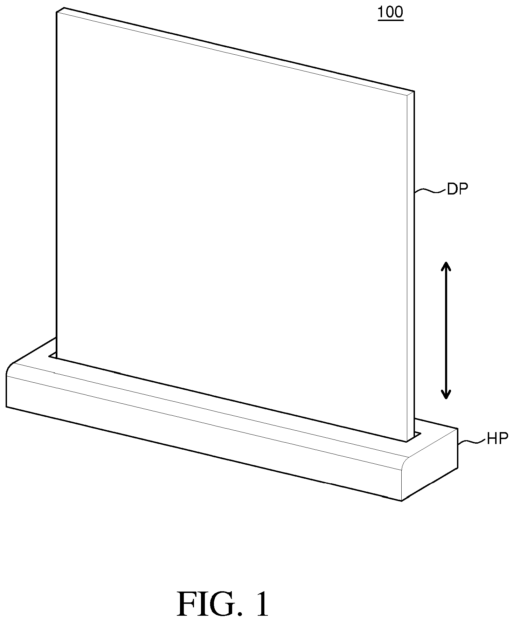

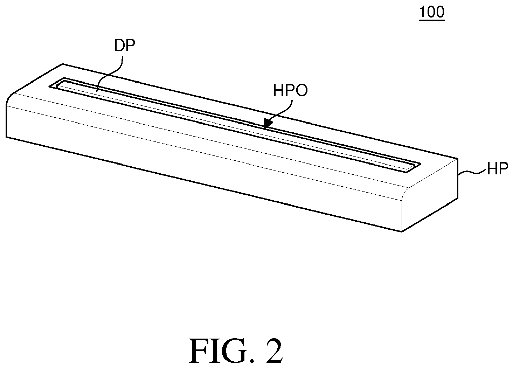

FIG. 1 is a perspective view of a display device in a fully unwound state according to an exemplary embodiment of the present disclosure. FIG. 2 is a perspective view of a display device in a fully wound state according to an exemplary embodiment of the present disclosure. Referring to FIGS. 1 and 2, a display device 100 according to an exemplary embodiment of the present disclosure includes a display unit DP and a housing unit HP.

First, the display device 100 according to the exemplary embodiment of the present disclosure may be a rollable display device which is capable of displaying images even though it is rolled. The rollable display device may have a high flexibility as compared with a general display device of the related art. Depending on whether to use a rollable display device, a shape of the rollable display device may be freely varied. Specifically, when the rollable display device is not used, the rollable display device is rolled to be stored with a reduced volume. In contrast, when the rollable display device is used, the rolled rollable display device is unfolded to be used.

The display unit DP is a configuration for displaying images to a user. For example, in the display unit, a display element and a circuit, a wiring line, and a component for driving the display element may be disposed. In this case, since the display device 100 according to an exemplary embodiment of the present disclosure is a rollable display device 100, the display unit DP may be configured to be wound and unwound. For example, the display unit DP may be formed of a display panel and a back cover each having flexibility to be wound or unwound.

The display panel is a panel for displaying images to the user. The display panel may include a display element which displays images, a driving element which drives the display element, and wiring lines which transmit various signals to the display element and the driving element. The display element may be defined in different ways depending on a type of the display panel. For example, when the display panel is an organic light emitting display panel, the display element may be an organic light emitting diode which includes an anode, an organic light emitting layer, and a cathode. For example, when the display panel is a liquid crystal display panel, the display element may be a liquid crystal display element.

A back cover is disposed on a rear surface of the display panel to support the display panel. The back cover may protect the display panel from the outside. The back cover is formed of a material having a rigidity and also has a flexibility to be wound or unwound together with the display panel.

The housing unit HP is a case in which the display unit DP is accommodated. The display unit DP may be wound to be accommodated in the housing unit HP. The display unit DP may be unwound to be disposed at the outside of the housing unit HP.

The housing unit HP may have an opening HPO so that the display unit DP moves to the inside and the outside of the housing unit HP. The display unit DP may move in a vertical direction through the opening HPO of the housing unit HP.

In the meantime, the display unit DP of the display device 100 may be switched from a fully unwound state to a fully wound state or from a fully wound state to a fully unwound state.

FIG. 1 illustrates a fully unwound state of the display unit DP of the display device 100. In the fully unwound state, the display unit DP of the display device 100 is disposed at the outside of the housing unit HP. A state in which the display unit DP is unwound to be disposed at the outside of the housing unit HP to the maximum so that it cannot be further unwound any more is defined as a fully unwound state. When the user watches the image through the display device 100, the display device 100 may be switched to a fully unwound state in which the display unit DP is flat and planar and preferably arranged vertically with respect to the housing unit HP, which is preferably arranged horizontal, or substantially horizontal. Moreover, the display unit DP extends from the housing unit HP such that the display unit DP is at the outside of the housing unit HP.

FIG. 2 illustrates a fully wound state of the display unit DP of the display device 100. In the fully wound state, the display unit DP of the display device 100 is accommodated in the housing unit HP. A state in which the display unit DP is wound to be disposed in the housing unit HP to the maximum so that it cannot be further wound any more is defined as a fully wound state. When the user does not watch the images through the display device 100, it is advantageous from the viewpoint of an outer appearance that the display unit DP is not disposed at the outside of the housing unit HP. Therefore, the display device 100 may be switched to a fully wound state in which the display unit DP is rolled to be accommodated in the housing unit HP. Further, when the display unit DP is in a fully wound state to be accommodated in the housing unit HP, a volume of the display device 100 is reduced and the display device 100 may be easily carried.

In the meantime, in order to switch the display unit DP to a fully wound state or a fully unwound state, a roller unit 110 and a driving unit 140 which winds or unwinds the display unit DP are disposed in the housing unit HP. A lifting unit 150 which lifts the display unit DP is disposed in the housing unit HP. A link unit 120 which connects the display unit DP and the lifting unit 150 is disposed on a rear surface of the display unit DP.

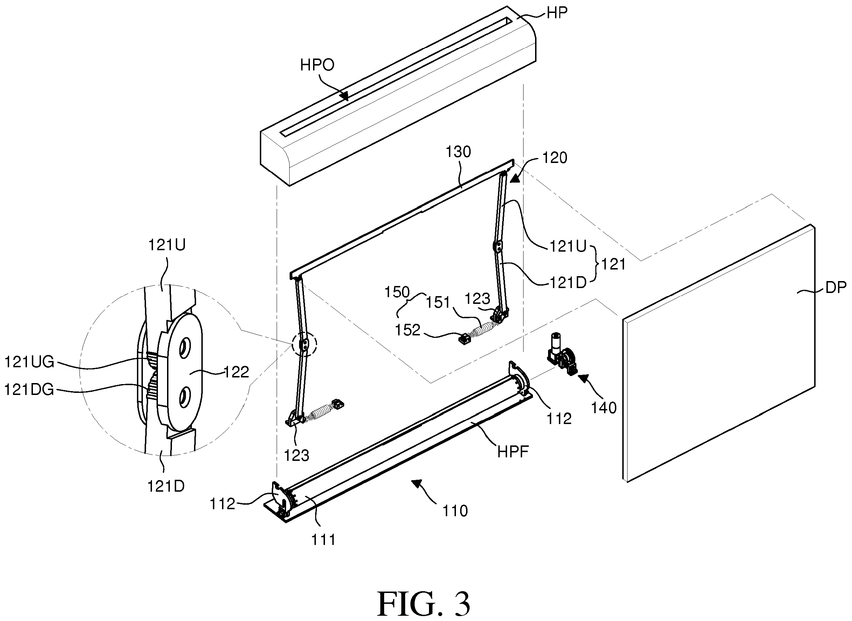

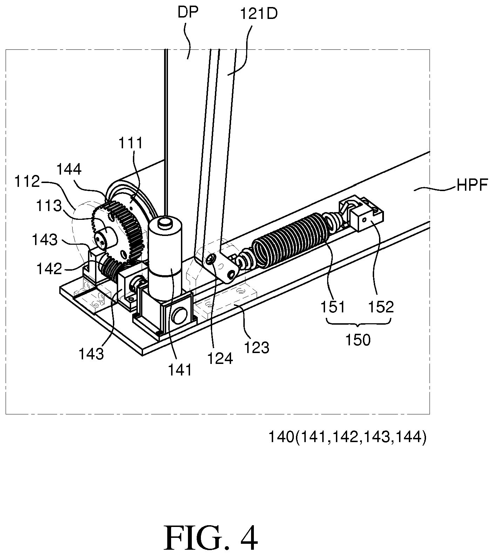

Hereinafter, the roller unit 110, the link unit 120, a head bar 130, the driving unit 140, and the lifting unit 150 will be described in detail with reference to FIGS. 3 and 4.

FIG. 3 is an exploded perspective view of a display device according to an exemplary embodiment of the present disclosure. FIG. 4 is an enlarged perspective view of a display device according to an exemplary embodiment of the present disclosure. FIG. 4 is an enlarged view of the driving unit 140 and the lifting unit 150 on the rear surface of the display device 100 in order to explain a connection relationship of the link unit 120 and the lifting unit 150 of the display device 100 and a connection relationship of the roller unit 110 and the driving unit 140. In FIG. 4, for the convenience of description, a roller support unit 112 and a link support unit 123 are illustrated with a dotted line.

Referring to FIGS. 3 and 4, the display device 100 according to an exemplary embodiment of the present disclosure includes the display unit DP, the housing unit HP, the roller unit 110, the link unit 120, the head bar 130, the driving unit 140, and the lifting unit 150.

The roller unit 110 rotates in a clockwise direction or a counterclockwise direction to winds or unwinds the display unit DP, respectively. In one embodiment, rotation of the roller unit 110 in the clockwise direction manipulates the display unit DP from the unwound state to the wound state, while in other embodiments, rotation of the roller unit 110 in the counterclockwise direction manipulates the display unit DP from the wound state to the unwound state. The roller unit 110 includes a roller 111, a roller support unit 112, and a roller shaft 113, which is received in a longitudinal bore of the roller 111. In other words, the roller shaft 113 is positioned in the roller 111 and extends beyond outer edges of the roller 111 to couple to the roller support unit 112.

The roller 111 is a member around which the display unit DP is wound. The roller 111 rotates in a clockwise direction or a counterclockwise direction and winds or unwinds the display unit DP fixed to the roller 111. The roller 111 may be, for example, formed to have a cylindrical shape.

The display unit DP is fixed to the roller 111. For example, a lower edge of the display unit DP may be fixed to the roller 111. When the roller 111 rotates in a clockwise direction, the display unit DP may be wound around the roller 111. When the roller 111 rotates in a counterclockwise direction, the display unit DP which is wound around the roller 111 may be unwound from the roller 111. However, the winding and unwinding of the display unit DP in accordance with the rotating direction of the roller 111 may vary depending on an arrangement relationship of the roller 111 and the display unit DP and whether one surface of the display unit DP which is in contact with an outer circumferential surface of the roller 111 is a front surface of the display unit DP or a rear surface of the display unit DP, but is not limited thereto.

The roller support unit 112 is disposed at both ends of the roller 111. The roller 111 is rotatably coupled to the roller support unit 112. Specifically, the roller shaft 113 protruding from both ends of the roller 111 is rotatably coupled to the roller support unit 112. The roller support unit 112 is disposed on a bottom surface HPF of the housing unit HP. A side upper end of the roller support unit 112 is coupled to the roller shaft 113 protruding from both ends of the roller 111. Therefore, the roller support units 112 may support the roller 111 to be spaced apart from the bottom surface HPF of the housing unit HP. Therefore, when the roller 111 rotates, the roller 111 and the display unit DP wound to the roller 111 do not interfere with or touch with the bottom surface HPF of the housing unit HP, even when the display unit DP is in the fully rolled configuration.

The link unit 120 may support the display unit DP. Specifically, the link unit 120 supports the display unit DP in the unrolled configuration from the roller 111 in a flat or planar state. Preferably, the link unit 120 supports the display unit DP in a vertical orientation relative to the housing unit HP. The link unit 120 includes a plurality of links 121, a link connecting unit 122, a link support unit 123, and a support shaft 124.

Each of the plurality of links 121 is connected to an upper side of the display unit DP. For example, one end of each of the plurality of links 121 is connected to both ends of the upper edge of the display unit DP to support the display unit DP which is unwound from the roller 111 to maintain a flat state.

Each of the plurality of links 121 includes an upper link 121U and a lower link 121D. The upper link 121U and the lower link 121D are rotatably coupled to each other to be folded or unfolded. That is, the upper link 121U and the lower link 121D rotate in a direction to be close to each other to be folded. The upper link 121U and the lower link 121D rotate in a direction away from each other to be unfolded.

One end of the upper link 121U is rotatably coupled to both ends of the upper edge of the display unit DP. Specifically, one end of the upper link 121U is rotatably coupled to the head bar 130 which is fixed to the upper edge of the display unit DP.

The head bar 130 is a member for connecting the display unit DP and the upper link 121U. The head bar 130 may be fixed to the upper edge of the display unit DP. The upper link 121U may be rotatably coupled to the head bar 130 and the head bar 130 may move in a vertical direction in accordance with the rotation of the upper link 121U. Therefore, the display unit DP fixed to the head bar 130 also may move in a vertical direction together with the head bar 130.

The other end of the upper link 121U is rotatably coupled to one end of the lower link 121D. A gear 121UG may be further disposed at the other end of the upper link 121U so that the other end of the upper link 121U is rotatably coupled to one end of the lower link 121D. For example, the gear 121UG disposed at the other end of the upper link 121U may have a shape of a spur gear, but is not limited thereto. The gear 121UG includes a plurality of teeth, splines, ribs, or like structures, such that the gear 121UG can be mechanically coupled or intermeshed a gear 121DG, as described herein.

One end of the lower link 121D is rotatably coupled to the other end of the upper link 121U. Similarly to the other end of the upper link 121U, a gear 121DG may be further disposed at one end of the lower link 121D. Further, similarly to the gear 121UG disposed at the other end of the upper link 121U, the gear 121DG disposed at one end of the lower link 121D may be formed to have a shape of a spur gear, but is not limited thereto. In other words, the gear 121DG includes a plurality of teeth, splines, ribs, or like structures such that the gear 121DG is mechanically coupled to the gear 121UG in an intermeshed configuration.

In the meantime, the link connecting unit 122 is disposed at the other end of the upper link 121U and one end of the lower link 121D. A shaft of a gear 121UG at the other end of the upper link 121U and a shaft of a gear 121DG at one end of the lower link 121D are connected to the link connecting unit 122. Therefore, the gear 121UG at the other end of the upper link 121U rotates around the shaft connected to the link connecting unit 122. The gear 121DG at one end of the lower link 121D rotates around the shaft connected to the link connecting unit 122. Saw teeth of the gear 121UG at the other end of the upper link 121U and saw teeth of the gear 121DG at one end of the lower link 121D are engaged with each other so that the upper link 121U also rotates in accordance with the rotation of the lower link 121D and the lower link 121D also rotates in accordance with the rotation of the upper link 121U.

The other end of the lower link 121D is coupled to the lifting unit 150. Specifically, since the other end of the lower link 121D is coupled to the lifting unit 150, the other end of the lower link 121D may rotate by the lifting unit 150.

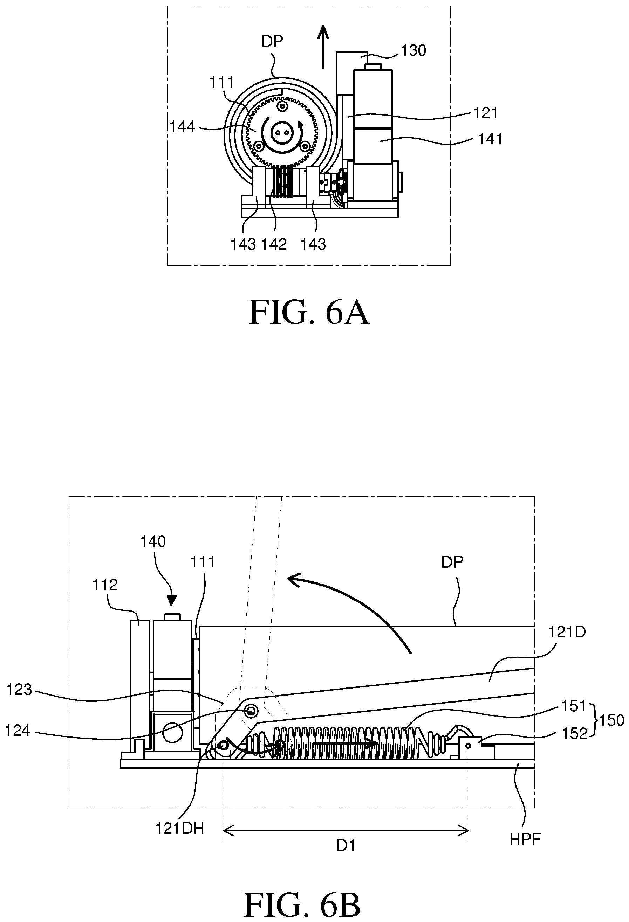

The lower link 121D is rotatably coupled to the support shaft 124 of the link support unit 123 at an arbitrary point between one end and the other end of the lower link 121D. Therefore, the lower link 121D may rotate by the lifting unit 150 with respect to the support shaft 124. Specifically, the lifting unit 150 rotates the other end of the lower link 121D around the support shaft 124 to lift the lower link 121D, which will be described below in detail with reference to FIGS. 6A and 6B.

The support shaft 124 protrudes near an upper end of one surface of the link support unit 123. The support shaft 124 is spaced apart from the bottom surface HPF of the housing unit HP. When the other end of the lower link 121D rotates by the lifting unit 150, the support shaft 124 may be disposed to be spaced apart from the bottom surface HPF of the housing unit HP so that the other end of the lower link 121D and the bottom surface HPF of the housing unit HP do not interfere with each other.

In one embodiment, the plurality of links 121 includes two links 121. Each of the links 121 includes the upper link 121U and the lower link 121D. The upper link 121U includes opposing one and other ends, wherein the one end is coupled to the head bar 130 and the other end is rotatably coupled to the lower link 121D, as shown in FIG. 3. The lower link 121D similarly includes opposing one and other ends, wherein the one end is coupled to the upper link 121U and the other end is coupled to the lifting unit 150 and the elastic member 151 via the link support unit 123. The head bar 130, and thus the upper link 121U is attached to the upper edge 105 of the display unit PD and the lower link 121D is coupled to the lifting unit 150 proximate the lower edge 103 of the display unit PD. As shown in FIG. 3, the other end of the upper link 121U and the one end of the lower link 121D include gears 121UG, 121DG, respectively, which are mechanically coupled to each other in an intermeshed or interlocked configuration via the link connecting unit 122. In other words, the link connecting unit 122 is coupled to each of the links 121U, 121D to secure the links 121U, 121D in a relationship wherein the links 121U, 121D can rotate relative to each other.

When the display unit DP is manipulated from the rolled configuration to the unrolled configuration, the lifting unit 150 acts with a force on the other end of the lower link 121D to pull the other end of the lower link 121D towards a center of the display unit DP, which causes rotation of the upper and lower links 121U, 121D towards vertical alignment in an unfolded configuration. Further, when the display unit DP is manipulated from the unrolled configuration to the rolled configuration, the lifting unit 150 acts with a similar force to or otherwise maintain the links 121U, 121D in the unfolded configuration, which is opposite to the force provided by the driving unit 140 to manipulate the display unit DP to the rolled configuration. As such, when the display unit DP is in any configuration (e.g. rolled, unrolled, or anywhere in between), the lifting unit 150 and the links 121 provide a force that tends to keep the display unit DP in a flat and planar orientation that is preferably vertical relative to the bottom surface HPF of the housing unit HP.

Referring to FIG. 4, the lifting unit 150 is connected to the plurality of links 121 to apply a force or a torque to the plurality of links 121 to be lifted. The lifting unit 150 includes an elastic member 151 and an elastic member fixing unit 152.

The elastic member 151 of the lifting unit 150 is disposed at the outside of the roller 111 to be connected to the plurality of links 121. The elastic member 151 is a member having an elastic force and is connected to the plurality of links 121 to apply the elastic force to the plurality of links 121 to be lifted. In other words, the elastic member 151 applies the elastic force to the plurality of links 121 to be unfolded so that the lower link 121D rotates in a direction in which the lower link 121D is disposed to be vertical to a lower edge and an upper edge of the display unit DP. The elastic member 151 may be, for example, a spring. However, as long as a member applies a force to the lower link 121D to rotate the other end of the lower link 121D, the elastic member is not limited thereto.

The elastic member 151 is disposed to be closer to a center area of the display unit DP, than the other end of the lower link 121D. That is, the elastic member 151 may be disposed between the other end of the lower link 121D of the link 121 disposed to be adjacent to one side of the display unit DP and the other end of the lower link 121D of the link 121 disposed to be adjacent to the other side of the display unit DP.

As described above, one end of the elastic member 151 is connected to the other end of the lower link 121D. Specifically, one end of the elastic member 151 may be rotatably coupled to the other end of the lower link 121D. For example, one end of the elastic member 151 is inserted into a hole 121DH formed at the other end of the lower link 121D so that the other end of the lower link 121D may rotate by the elastic force of the elastic member 151.

The other end of the elastic member 151 is connected to the elastic member fixing unit 152. Specifically, the elastic member fixing unit 152 is fixed to the bottom surface HPF of the housing unit HP and the other end of the elastic member 151 may be connected to the elastic member fixing unit 152. The elastic member 151 may be contracted or expanded with respect to the elastic member fixing unit 152. The other end of the lower link 121D connected to one end of the elastic member 151 also rotates in accordance with contraction and expansion of the elastic member 151. The elastic member 151 may be contracted or expanded by the rotation of the other end of the lower link 121D and the length of the elastic member 151 may vary.

The driving unit 140 is disposed at the outside of the roller 111 to rotate the roller 111. The driving unit 140 is disposed to be adjacent to at least one of both ends of the roller 111 to be connected to the roller 111. The driving unit 140 may rotate the roller 111 in a clockwise direction or a counterclockwise direction and the display unit DP may be wound or unwound around the rotating roller 111.

The driving unit 140 generates a torque to rotate the roller 111 and apply the generated torque to the roller 111. The driving unit 140 includes a motor 141, a worm gear 142, a worm gear support unit 143, and a worm wheel 144.

The motor 141 applies a torque to the roller 111 to rotate the roller 111. The motor 141 applies the torque to the roller 111 to rotate the roller 111 in a clockwise direction or applies the torque to the roller 111 to rotate the roller 111 in a counterclockwise direction.

In order to transmit the torque from the motor 141 to the roller 111, the worm gear 142 and the worm wheel 144 are disposed between the motor 141 and the roller 111. The worm gear 142 and the worm wheel 144 are transmission members which transmit the torque generated in the motor 141 to the roller 111 and rotate in a clockwise direction or a counterclockwise direction by the torque of the motor 141.

Saw teeth are formed on outer circumferential surfaces of the worm gear 142 and the worm wheel 144. The worm gear 142 and the worm wheel 144 are disposed such that the saw teeth of the worm gear 142 and the saw teeth of the worm wheel 144 are engaged with each other. The worm gear 142 may rotate around a shaft of the worm gear 142 in a clockwise direction or a counterclockwise direction by the torque generated from the motor 141. The worm wheel 144 whose saw teeth are engaged with the saw teeth of the worm gear 142 also rotates around a shaft of the worm wheel 144 in a clockwise direction or a counterclockwise direction.

The worm gear support unit 143 is disposed on both ends of the worm gear 142. The worm gear 142 may be coupled to the worm gear support unit 143 to rotate both ends. The worm gear 142 is disposed in a lower portion of the worm wheel 144 to transmit the torque of the motor 141 to the worm wheel 144. In this case, the worm gear 142 may be supported by the worm gear support unit 143 to be spaced apart from the bottom surface HPF of the housing unit HP. Therefore, when the worm gear 142 rotates by the torque from the motor 141, the worm gear 142 may not interfere with the bottom surface HPF of the housing unit HP.

The worm wheel 144 may be fixed to the roller shaft 113. For example, the worm wheel 144 and the roller shaft 113 may be integrally formed or the worm wheel 144 and the roller shaft 113 may be separately formed to be fixed. Therefore, the roller 111 also rotates in a clockwise direction or a counterclockwise direction in accordance with the rotation of the worm wheel 144.

In the meantime, even though in FIG. 4, it is described that the driving unit 140 is configured by the motor 141, the worm gear 142, the worm gear support unit 143, and the worm wheel 144, as long as the driving unit 140 rotates the roller 111 in the clockwise direction or the counterclockwise direction, the driving unit 140 is not limited thereto. For example, in order to transmit the torque of the motor 141 to the roller 111, instead of the worm gear 142 and the worm wheel 144, a member such as a chain or a belt may be used or a geared motor may be directly connected to the roller 111 and it is not limited thereto.

Further, even though in FIG. 4, it is illustrated that the driving unit 140 is disposed at any one of both ends of the roller 111, the driving unit 140 may be disposed on both ends of the roller 111 to rotate the roller 111, and is not limited thereto.

In the meantime, the display unit DP may be wound around the roller 111 which rotates by the driving unit 140.

The display unit DP may be unwound by the roller 111 which rotates by the driving unit 140 and the plurality of links 121 which is unfolded by the elastic member 151. In this case, the elastic member 151 unfolds the plurality of links 121 to support the display unit DP such that the display unit DP connected to the plurality of links 121 is maintained in a flat, planar, and preferably vertical orientation relative to the housing unit HP via the plurality of links 121.

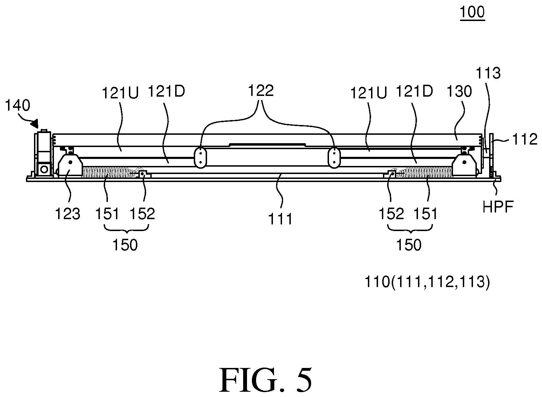

Hereinafter, a driving operation that a fully wound display unit DP is unwound will be described in detail with reference to FIGS. 5 to 6B.

FIG. 5 is a rear view of a display device in a fully wound state according to an exemplary embodiment of the present disclosure. FIGS. 6A and 6B are schematic views for explaining a driving unit and an elastic member when a display device according to an exemplary embodiment of the present disclosure is unwound. Specifically, FIG. 6A is an enlarged side view of a display device 100 according to an exemplary embodiment of the present disclosure. FIG. 6B is an enlarged rear view of a display device 100 according to an exemplary embodiment of the present disclosure. In FIGS. 5 to 6B, in order to describe the roller unit 110, the driving unit 140, and the lifting unit 150 disposed in the housing unit HP, only the bottom surface HPF of the housing unit HP is illustrated.

Referring to FIG. 5, the display unit DP is in a fully wound state which is fully wound around the roller 111.

In the fully wound state, the plurality of links 121 is folded such that the upper link 121U and the lower link 121D overlap each other. Specifically, the upper link 121U and the lower link 121D of the link 121 which is adjacent to one side of the display unit DP, among the plurality of links 121 are folded to overlap each other. The upper link 121U and the lower link 121D of the link 121 which is adjacent to the other side of the display unit DP, among the plurality of links 121, are folded to overlap each other.

Further, the plurality of links 121 is disposed to be horizontal to the upper edge and the lower edge of the display unit DP. In the plurality of links 121, the other end of the lower link 121D may be disposed to be farther from the center area of the display unit DP than one end of the lower link 121D. In the plurality of links 121, the other end of the upper link 121U may be disposed to be closer to the center area of the display unit DP than one end of the upper link 121U.

In the meantime, even though the force of the lifting unit 150 which lifts the plurality of links 121 is applied to the plurality of links 121 in a fully wound state, the plurality of links 121 may maintain a folded state by the driving unit 140. In the fully wound state, the driving unit 140 may fix the roller 111 so that the display unit DP is not unwound. The display unit DP may maintain a fully wound state around the roller 111 by the driving unit 140. The plurality of links 121 connected to the head bar 130 at the upper edge of the display unit DP may also maintain a folded state without being lifted. Therefore, the driving unit 140 may maintain the fixed state of the roller 111 so as not to rotate the roller 111, so that the display unit DP may maintain a wound state around the roller 111 and the plurality of links 121 connected to the head bar 130 may also maintain a folded state.

Hereinafter, a driving operation of the driving unit 140 and the lifting unit 150 when the display unit DP fully wound around the roller 111 is unwound from the roller 111 will be described with reference to FIGS. 6A and 6B.

Referring to FIG. 6A, the driving unit 140 rotates the roller 111 in a counterclockwise direction. Specifically, the motor 141 rotates the worm gear 142 in a clockwise direction or a counterclockwise direction in accordance with an engagement state of saw teeth of the worm gear 142 and the worm wheel 144. The worm wheel 144 whose saw teeth are engaged with the saw teeth of the worm gear 142 may rotate in a counterclockwise direction in accordance with the rotation of the worm gear 142. Therefore, the driving unit 140 rotates the roller 111 in a counterclockwise direction to unwind the display unit DP which is wound around the roller 111 from the roller 111.

Referring to FIG. 6B, the display unit DP is unwound from the roller 111 by the driving unit 140 and the elastic member 151 of the lifting unit 150 may apply an elastic force to the plurality of links 121 so as to be lifted.

First, in the fully wound state, the driving unit 140 may fix the roller 111 so as not to rotate. The plurality of links 121 may also maintain a folded state by the driving unit 140.

When the display unit DP is unwound, the driving unit 140 may rotate the roller 111. The force of the driving unit 140 which maintains the plurality of links 121 in a folded state is also removed so that the plurality of links 121 does not maintain the folded state and may be unfolded by the elastic member 151.

In the meantime, in the fully wound state, a length from one end of the elastic member 151 to the other end may be a first length D1. Specifically, in the fully wound state, the elastic member 151 may be expanded to the maximum. Therefore, the first length D1 may be a maximum length of the elastic member 151.

Specifically, the other end of the elastic member 151 is fixed to the elastic member fixing unit 152 and one end of the elastic member 151 may move in accordance with the rotation of the lower link 121D. In this case, as described above, in the fully wound state, the driving unit 140 may fix the roller 111 so as not to rotate and the plurality of links 121 connected to the head bar 130 of the upper edge of the display unit DP may also maintain a folded state. In other words, fixing the driving unit 140 prevents movement of the links 121 and the head bar 130, which prevents the display unit DP from unrolling. In this case, the other end of the lower link 121D may be disposed to be farthest from the center area of the display unit DP as compared with other parts. One end of the elastic member 151 connected to the other end of the lower link 121D may also move to be away from the center area of the display unit DP. Therefore, the elastic member 151 may be expanded. Therefore, until the driving unit 140 stops fixing the roller 111, the elastic member 151 may maintain the maximum expansion state by the force of the driving unit 140 and the elastic member 151 may have a first length D1 which is a maximum length.

In the fully wound state, when the driving unit 140 stops fixing the roller 111 and rotates the roller 111 to unwind the display unit DP, the force of the driving unit 140 which is applied to the elastic member 151 is also removed so that the elastic member 151 which is in a maximum expanded state by the driving unit 140 may be contracted to go back to its original state. Therefore, one end of the elastic member 151 may move toward the elastic member fixing unit 152 with respect to the other end of the elastic member 151 and the elastic member fixing unit 152. In other words, one end of the elastic member 151 may move to be close to the center area of the display unit DP.

Therefore, when the display unit DP is unwound, the elastic member 151 may rotate the other end of the lower link 121D of the plurality of links 121 so that the plurality of folded links 121 is unfolded. That is, the elastic member 151 may rotate the other end of the lower link 121D to lift the plurality of links 121 by the elastic force of the elastic member 151 form its maximum expanded state to its original or resting state.

The other end of the lower link 121D may rotate so as to be close to the center area of the display unit DP by the elastic member 151. The lower link 121D may rotate with respect to the support shaft 124 by the rotation of the other end of the lower link 121D. For example, the lower link 121D may rotate in a direction vertical to the bottom surface HPF of the housing unit HP.

Therefore, when the display unit DP is unwound, the driving unit 140 rotates the roller 111 to allow the display unit DP to be unwound from the roller 111 and the force of the driving unit 140 which is applied to the elastic member 151 is removed. Therefore, the elastic member 151 may be contracted. As the elastic member 151 is contracted, one end of the elastic member 151 may move to be close to the center area of the display unit DP and the other end of the lower link 121D connected to one end of the elastic member 151 also rotates to be closer to the center area of the display unit DP. Therefore, the lower link 121D and the upper link 121U connected to the lower link 121D may be lifted.

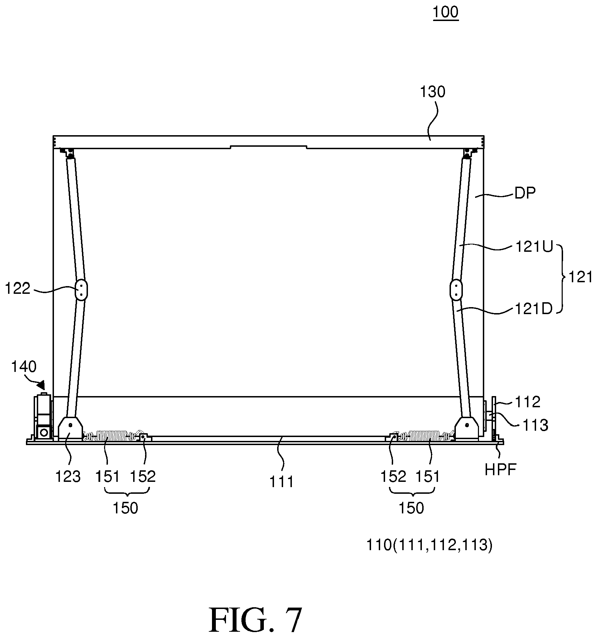

Hereinafter, a driving operation that a fully unwound display unit DP is wound will be described in detail with reference to FIGS. 7 to 8B.

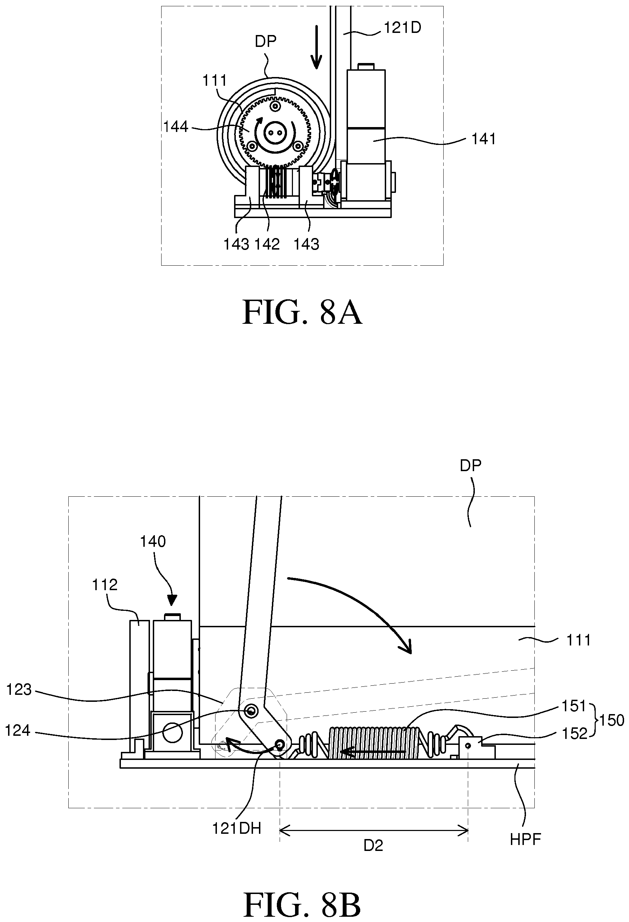

FIG. 7 is a rear view of a display device in a fully unwound state according to an exemplary embodiment of the present disclosure. FIGS. 8A and 8B are schematic views for explaining a driving unit and an elastic member when a display device according to an exemplary embodiment of the present disclosure is wound. Specifically, FIG. 8A is an enlarged side view of a display device 100 according to an exemplary embodiment of the present disclosure. FIG. 8B is an enlarged rear view of a display device 100 according to an exemplary embodiment of the present disclosure. In FIGS. 7 to 8B, in order to describe the roller unit 110, the driving unit 140, and the lifting unit 150 disposed in the housing unit HP, only the bottom surface HPF of the housing unit HP is illustrated.

Referring to FIG. 7, the display unit DP is in a fully unwound state which is fully unwound from the roller 111.

In the fully unwound state, the upper link 121U and the lower link 121D are fully unfolded in each of the plurality of links 121. Specifically, the upper link 121U and the lower link 121D of the link 121 which is adjacent to one side of the display unit DP, among the plurality of links 121, are unfolded as close as possible to the straight line. The upper link 121U and the lower link 121D of the link 121 which is adjacent to the other side of the display unit DP, among the plurality of links 121, are unfolded as close as possible to vertical (e.g. the links 121U, 121D are aligned in a the straight line). For example, the upper link 121U and the lower link 121D are unfolded to the maximum so that an angle between the upper link 121U and the lower link 121D may form an obtuse angle which is larger than 90 degrees and smaller than 180 degrees, or form 180 degrees, or may be larger than 180 degrees, but is not limited thereto.

The plurality of links 121 is disposed to be vertical to the upper edge and the lower edge of the display unit DP. In each of the plurality of links 121, the other end of the lower link 121D may be disposed to be closer to the lower edge of the display unit DP, the roller 111, and the bottom surface HPF of the housing unit HP than one end of the lower link 121D. In each of the plurality of links 121, the other end of the upper link 121U may be disposed to be closer to the lower edge of the display unit DP, the roller 111, and the bottom surface HPF of the housing unit HP than one end of the upper link 121U.

The plurality of links 121 may maintain the unfolded state by the driving unit 140 and the lifting unit 150. The driving unit 140 may fix the roller 111 so that the display unit DP is not wound around the roller 111 in the fully unwound state of the display unit DP. That is, the display unit DP may maintain a fully unwound state by the driving unit 140. The plurality of links 121 connected to the head bar 130 at the upper edge of the display unit DP may maintain an unfolded state by the lifting unit 150 without being lowered by the driving unit 140. In this case, the lifting unit 150 may continuously apply the force to unfold the plurality of links 121 regardless of the winding or unwinding of the display unit DP due to the force exerted by the elastic member 151. Therefore, the lifting unit 150 applies the force to the plurality of links 121 so that the plurality of links 121 is unfolded and the plurality of links 121 is unfolded by the lifting unit 150 to be lifted. Therefore, the head bar 130 and the display unit DP connected to the plurality of links 121 may also be lifted together with the plurality of links 121 which is unfolded by the lifting unit 150.

Further, while switching from the fully wound state to the fully unwound state or switching from the fully unwound state to the fully wound state, the plurality of links 121 which is applied with a force from the lifting unit 150 to be unfolded all the time may support a part of the display unit DP which is not wound around the roller 111 to be lowered or lifted while maintaining a flat state. In other words, regardless of the configuration of the display unit DP (e.g. rolled or unrolled), a portion of the display unit DP may remain unrolled, in which case, the plurality of links 121 and the lifting unit 150 support the portion of the display unit DP in the unrolled configuration.

For the purpose of description of a specific driving operation of the driving unit 140 and the lifting unit 150, referring to FIG. 8A, the driving unit 140 rotates the roller 111 in a clockwise direction. Specifically, the motor 141 rotates the worm gear 142 in a counterclockwise direction or the clockwise direction and the worm wheel 144 may rotate in a clockwise direction in accordance with the rotation of the worm gear 142. Therefore, the driving unit 140 rotates the roller 111 in a clockwise direction to wind the display unit DP around the roller 111. In other words, the driving unit 140 rotates the roller 111 to which the display unit DP is fixed, which manipulates the display unit DP from the unrolled configuration to the rolled configuration.

Referring to FIG. 8B, the display unit DP is wound around the roller 111 by the driving unit 140. However, when the display unit DP is wound around the roller 111 by the driving unit 140, the elastic member 151 of the lifting unit 150 may apply an elastic force to the plurality of links 121 so as to be lifted. In one embodiment, the force applied by the driving unit 140 is greater than the force applied to the links 121 by the lifting unit 150, and as such, the driving unit 140 causes the display unit DP to be wound around the roller 111 while also folding the links 121 and expanding the elastic member 151, as described herein. However, more preferably, the force applied by the driving unit 140 is less than the force applied to the links 121 by the lifting unit 150, but because of the arrangement of the links 121 and the support shaft 124, greater torque is generated by the driving unit 140 as compared to the lifting unit 150, as described herein.

First, in the fully unwound state, the driving unit 140 fixes the roller 111 so as not to rotate and the lifting unit 150 may apply a force to the plurality of links 121 so as to also maintain an unfolded state. When the display unit DP is wound, the driving unit 140 may rotate the roller 111 and the lifting unit 150 applies a force to the plurality of links 121 to be unfolded. The plurality of links 121 may be folded by the force of the driving unit 140.

In this case, the force of the driving unit 140 may be smaller than the force of the lifting unit 150. Specifically, the motor 141 of the driving unit 140 winds the display unit DP around the roller 111 to lower the display unit DP. The upper link 121U connected to the head bar 130 at the upper edge of the display unit DP may also be lowered by the force of the driving unit 140 which lowers the display unit DP together with the display unit DP. That is, the driving unit 140 may apply the force to the head bar 130, the upper link 121U, and one end of the lower link 121D connected to the upper link 121U. The driving unit 140 applies the force to one end of the lower link 121D to rotate the lower link 121D with respect to the support shaft 124, thereby lowering the lower link 121D and the upper link 121U.

Further, the lifting unit 150 rotates the other end of the lower link 121D with respect to the support shaft 124 to lift the lower link 121D and the upper link 121U. The head bar 130 and the display unit DP connected to the lower link 121D and the upper link 121U may also be lifted together with the link 121 by the force of the lifting unit 150. That is, the lifting unit 150 applies the force to the other end of the lower link 121D to rotate the lower link 121D with respect to the support shaft 124 so as to lift the upper link 121U connected to the lower link 121D.

In summary, when the display unit DP is wound, the driving unit 140 may apply the force to one end of the lower link 121D so that one end of the lower link 121D rotates with respect to the support shaft 124 to be lowered. The lifting unit 150 may apply the force to the other end of the lower link 121D so that the other end of the lower link 121D rotates with respect to the support shaft 124 to be lifted. Therefore, the lower link 121D may be lifted or lowered by the force of the driving unit 140 and the force of the lifting unit 150 which are applied to one end and the other end, respectively.

In this case, a length from one end of the lower link 121D proximate the top edge of the display unit DP to the support shaft 124 may be longer than a length from the other end of the lower link 121D proximate bottom edge of the display unit DP to the support shaft 124. Further, the farther the point where the force is applied with respect to the support shaft 124, the smaller the force is applied to rotate the lower link 121D. Specifically, the lower link 121D is a body of rotation which rotates with respect to the support shaft 124 and the body of rotation may rotate by the torque. The torque may be determined by multiplying the length from the support shaft 124 to a point where the force is applied and a magnitude of force. Therefore, the longer the length to the point which is applied with the force from the support shaft 124, the larger the torque.

For example, the length from one end of the lower link 121D to the support shaft 124 is larger than the length from the other end of the lower link 121D to the support shaft 124. Therefore, even though the force of the driving unit 140 which is applied to one end of the lower link 121D is smaller than the force of the lifting unit 150 applied to the other end of the lower link 121D, the torque at one end of the lower link 121D may be stronger. Therefore, even though the force of the driving unit 140 is smaller than the force of the lifting unit 150, the driving unit 140 may lower the lower link 121D. Therefore, when the display unit DP is wound, the driving unit 140 applies the force so as to lower the lower link 121D and the lifting unit 150 applies the force to lift the lower link 121D, which is opposite to the driving unit 140. Therefore, the torque applied to one end of the lower link 121D is larger so that the lower link 121D may be lowered together with the display unit DP.

Therefore, the force of the driving unit 140 and the force of the lifting unit 150 may be designed in consideration of a length from the support shaft 124 to one end of the lower link 121D and the length from the support shaft 124 to the other end of the lower link 121D.

In the meantime, in the fully unwound state, a length from one end of the elastic member 151 to the other end of the elastic member 151 may be a second length D2. Specifically, in the fully unwound state, the elastic member 151 may be contracted to the maximum. Therefore, the second length D2 may be a minimum length of the elastic member 151.

Specifically, in the fully unwound state, the elastic member 151 may be contracted to the maximum by the driving unit 140 and the lifting unit 150. The other end of the elastic member 151 is fixed to the elastic member fixing unit 152 and one end of the elastic member 151 may move in accordance with the rotation of the lower link 121D. In this case, as described above, in the fully unwound state, the driving unit 140 may fix the roller 111 so as not to rotate the roller 111 so that the display unit DP is not wound around the roller 111, that is, the display unit DP is not lowered. Further, the plurality of links 121 may be not applied with the force so as to be lowered by the driving unit 140. Therefore, the plurality of links 121 may maintain the unfolded state to the maximum by the lifting unit 150. In this case, the other end of the lower link 121D may rotate with respect to the support shaft 124 so as to be close to the center area of the display unit DP to be disposed to be vertical to the bottom surface HPF of the housing unit HP. One end of the elastic member 151 connected to the other end of the lower link 121D may also move to be close to the center area of the display unit DP to be contracted. Therefore, before the driving unit 140 applies the force to lower the display unit DP, the elastic member 151 is not expanded by the driving unit 140, but contracted to be back to its original state so that the elastic member 151 may have a second length D2 which is the minimum length.

In the meantime, when the driving unit 140 rotates the roller 111 to wind the display unit DP again, the elastic member 151 which is contracted to the maximum in the fully unwound state may be expanded again by the force of the driving unit 140 applied to the elastic member 151. Therefore, one end of the elastic member 151 may move to be away from the elastic member fixing unit 152 with respect to the other end of the elastic member 151 fixed to the elastic member fixing unit 152. In other words, one end of the elastic member 151 may move to be away from the center area of the display unit DP.

Therefore, when the display unit DP is wound, the driving unit 140 may rotate the other end of the lower link 121D of the plurality of links 121 so that the plurality of unfolded links 121 is folded. That is, the driving unit 140 may rotate the other end of the lower link 121D to lower the plurality of links 121.

The other end of the lower link 121D may rotate so as to be away from the center area of the display unit DP by the driving unit 140. Further, the lower link 121D may rotate with respect to the support shaft 124 by the rotation of the other end of the lower link 121D and for example, the lower link 121D may rotate to be horizontal to the bottom surface HPF of the housing unit HP.

Therefore, when the display unit DP is wound, the driving unit 140 rotates the roller 111 to allow the display unit DP to be wound around the roller 111 and the elastic member 151 may be expanded by the force of the driving unit 140 which rotates the lower link 121D. As the elastic member 151 expands, one end of the elastic member 151 may move to be away from the center area of the display unit DP and the other end of the lower link 121D connected to one end of the elastic member 151 also rotates to be away from the center area of the display unit DP. Therefore, the lower link 121D and the upper link 121U connected to the lower link 121D may be lowered.

The display device 100 according to the exemplary embodiment of the present disclosure includes the driving unit 140 which rotates the roller 111 and the driving unit 140 directly rotates the roller 111 to precisely control the roller 111. Specifically, the display device 100 according to the exemplary embodiment of the present disclosure includes the driving unit 140 which is coupled to any one of both ends of the roller 111 at the outside of the roller 111. The driving unit 140 is a member which generates a torque and the torque generated in the driving unit 140 may rotate the roller 111 in both directions. In this case, the display unit DP fixed to the roller 111 may be wound or unwound around the roller 111 in accordance with the rotating direction of the roller 111. The driving unit 140 connected to the roller 111 may wind or unwind the display unit DP around the roller 111 or control a speed of the display unit DP which is wound or unwound to the roller 111. The lifting unit 150 is also connected to an upper portion of the display unit DP to apply the force so as to lift the display unit DP while maintaining a flat state. However, the lifting unit 150 also operates depending on whether the driving unit 140 fixes the roller 111 or rotates the roller 111. That is, even though the force is applied from the lifting unit 150 to lift the display unit DP, the driving unit 140 rotates the roller 111 to wind and lower the display unit DP. Therefore, even though the force from the lifting unit 150 is applied to the display unit DP and the plurality of links 121, the display device 100 according to the exemplary embodiment of the present disclosure may sufficiently rotate the roller 111 in both directions or fix the roller 111 with the force of the driving unit 140 and control the display unit DP and the plurality of links 121. Put another way, the fixing force applied by the driving unit 140 controls operation of the lifting unit 150, as the fixing force holds the links 121 in the unfolded or folded state, which results in the display unit DP remaining the unrolled or rolled configurations, respectively. When the display unit DP is manipulated to the unrolled configuration, the force exerted by the lifting unit 150 assists in raising the display unit DP.

The display device 100 according to the exemplary embodiment of the present disclosure includes the lifting unit 150 which is connected to an upper edge of the display unit DP and the lifting unit 150 may maintain the display unit DP to be flat. Specifically, the elastic member 151 of the lifting unit 150 is connected to the other end of the lower link 121D at each of the plurality of links 121 to apply the force so that the lower link 121D rotates with respect to the support shaft 124. The other end of the lower link 121D rotates with respect to the support shaft 124 by the elastic member 151 to lift the lower link 121D and the upper link 121U connected to the lower link 121D is also lifted. Therefore, the head bar 130 connected to the plurality of links 121 is also lifted to lift the display unit DP whose upper edge is fixed to the head bar 130. In this case, while winding or unwinding the display unit DP in a state in which the lower edge of the display unit DP is fixed to the roller 111, at least a part including the lower edge of the display unit DP may be wound around the roller 111. In a state in which a lower portion of the display unit DP is fixed to the roller 111 or wound around the roller 111 to be lowered, or unwound from the roller 111, the upper edge of the display unit DP may be maintained to be lifted by the lifting unit 150 at all times. Therefore, at least a part of the display unit DP which is unwound from the roller 111 is lifted by the lifting unit 150 to be maintained in a flat state. Therefore, a degree of flatness of the display unit DP may be adjusted by the lifting unit 150 and the degree of flatness of the display unit DP may be easily adjusted by adjusting the force of the lifting unit 150. For example, when the elastic member 151 of the lifting unit 150 is a spring, the degree of flatness of the display unit DP may be adjusted only by adjusting a constant of the spring. Therefore, the lifting unit 150 of the display device 100 according to the exemplary embodiment of the present disclosure applies the force so as to continuously lift at least a part of the display unit DP which is unwound from the roller 111 to maintain the flat state of the display unit DP and adjusts the force of the lifting unit 150 to simply adjust the degree of flatness of the display unit DP.

The display device 100 according to the present disclosure simplifies a configuration for winding or unwinding the display unit DP to reduce the volume of the display device 100. Specifically, in order to wind or unwind the display unit DP, a roller 111 around which the display unit DP is rolled and the plurality of links 121 which supports the display unit DP to maintain a flat state may be disposed. The roller 111 and the plurality of links 121 are members which are applied with the force from the outside to be operated. In this case, the roller 111 is applied with the force from the driving unit 140 to rotate the roller 111 and wind or unwind the display unit DP. Further, the plurality of links 121 is applied with the force from the lifting unit 150 to lift the plurality of links 121 and support the display unit DP to be flat. In this case, the driving unit 140 is directly connected to the roller 111 so that the force of the driving unit 140 may be directly applied to the roller 111 without using an intermediate medium which transmits the force from the driving unit 140. The lifting unit 150 is directly connected to the plurality of links 121 so that the force of the lifting unit 150 may be directly applied to the plurality of links 121 without using an intermediate medium which transmits the force from the lifting unit 150. Therefore, the driving unit 140 directly applies the force to the roller 111 and the lifting unit 150 directly applies the force to the plurality of links 121 so that the intermediate medium which transmits the force may be omitted. Therefore, the display device 100 according to the exemplary embodiment of the present disclosure may simplify the configuration of the display device 100 and reduce the volume of the display device 100.

The display device 100 of the present disclosure disposes the driving unit 140 and the lifting unit 150 at the outside of the roller 111 to increase the degree of freedom of design of the driving unit 140 and the lifting unit 150. In the related art, the elastic member is disposed in the roller so that the size of the elastic member is restricted and it is not easy to change the elastic member. In contrast, in the display device 100 according to the exemplary embodiment of the present disclosure, the driving unit 140 is connected to the roller 111 at the outside of the roller 111 and the lifting unit 150 is connected to the plurality of links 121 at the outside of the roller 111. Therefore, the size of the roller 111 is not limited and only the driving unit 140 may be easily replaced with another driving unit 140 without dissembling the roller 111 or move the position. The lifting unit 150 is not limited by the size of the roller 111 and only the lifting unit 150 may be easily replaced with another lifting unit 150 without dissembling the roller 111 and the plurality of links 121 or move the position. Therefore, in the display device 100 according to the exemplary embodiment of the present disclosure, the driving unit 140 and the lifting unit 150 are disposed at the outside of the roller 111 to easily repair, rearrange, or change the driving unit 140 and the lifting unit 150. Further, even though a design of the display device 100 such as an inch or a curvature is changed, the display device 100 may be implemented with a minimum modification, thereby increasing the degree of freedom of design.

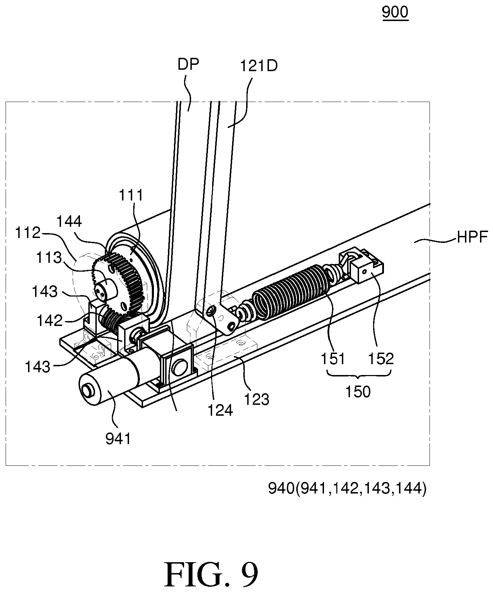

FIG. 9 is an enlarged perspective view for explaining a driving unit, a roller, an elastic member, and a link of a display device according to another exemplary embodiment of the present disclosure. The configuration of the display device 900 of FIG. 9 is the same as that of the display device 100 of FIGS. 1 to 8B except for the arrangement of a motor 941 of a driving unit 940, so that a redundant description will be omitted.

Referring to FIG. 9, the driving unit 940 is disposed at the outside of the roller 111 to be connected to the roller 111. Specifically, the driving unit 940 is disposed to be adjacent to any one of both ends of the roller 111 to be connected to the roller 111.

A motor 941 of the driving unit 940 is not vertically erected from the bottom surface HPF of the housing unit HP, but may be disposed to be laid on the bottom surface HPF of the housing unit HP. For example, the motor 941 rotates toward the bottom surface HPF of the housing unit HP with respect to the worm gear 142 so that the side of the motor 941 may be opposite to the bottom surface HPF of the housing unit HP. Since the motor 941 is disposed to be laid, the height of the motor 941 from the bottom surface HPF of the housing unit HP may be reduced.

In the display device 900 according to another exemplary embodiment of the present disclosure, the arrangement of the driving unit 940 is modified to lower the height of the housing unit HP and reduce the volume of the housing unit HP. Specifically, the display device 900 according to another exemplary embodiment of the present disclosure does not dispose the motor 941 of the driving unit 940 to be erected, but may dispose the motor 941 to be laid. Therefore, the height of the motor 941 from the bottom surface HPF of the housing unit HP may be lowered. Therefore, the height of the housing unit HP which is designed in consideration of the height of the motor 941 is also designed to be lower and thus the volume of the housing unit HP is also reduced. Therefore, the display device 900 according to another exemplary embodiment of the present disclosure may freely change the design of the driving unit 940 to reduce the volume of the display device 900.

Further, the display device 900 according to another exemplary embodiment of the present disclosure may freely change the arrangement of the driving unit 940 and may be designed in various ways. The driving unit 940 is disposed at the outside of the roller 111 to be connected to the roller 111. Therefore, in order to change the design of the driving unit 940, only the driving unit 940 may be modified without changing the size of the roller 111 or the arrangement of the roller 111. Therefore, the driving unit 940 may be disposed to be erected or laid. The driving unit 940 may be easily replaced. Therefore, in the display device 900 according to another exemplary embodiment of the present disclosure, the driving unit 940 is disposed at the outside of the roller 111 so that the design or the arrangement of the driving unit 940 may be freely changed regardless of the roller 111 so that the degree of freedom of design may be increased.

The exemplary embodiments of the present disclosure can also be described as follows:
According to an aspect of the present disclosure, there is provided a display device. The display device includes a display panel, a roller to which a lower edge of the display panel is fixed, a plurality of links having one end connected to an upper edge of the display panel, a driving unit which is disposed at the outside of the roller to rotate the roller, and an elastic member which is connected to the other end of each of the plurality of links to be disposed at the outside of the roller.

The driving unit may be connected to at least one of both ends of the roller to rotate the roller in a clockwise direction or a counterclockwise direction.

Each of the plurality of links may be connected to the upper edge of the display panel through a head bar.

Each of the plurality of links may include a lower link having the other end coupled to the elastic member, and an upper link having one end rotatably coupled to the upper edge of the display panel and the other end rotatably coupled to one end of the lower link.

The lower link may be rotatably coupled to a support shaft, and the elastic member may rotate the other end of the lower link around the support shaft to lift the lower link.

One end of the elastic member may be rotatably coupled to the other end of the lower link, and a length of the elastic member in a fully wound state of the display panel may be longer than a length of the elastic member in a fully unwound state of the display panel.

The elastic member may have an elastic force which rotates the other end of the lower link to lift each of the plurality of links.

In a fully unwound state of the display panel, the plurality of links may be disposed to be vertical to the upper edge of the display panel, the other end of the lower link may be disposed to be closer to the lower edge of the display panel than the one end of the lower link, and the other end of the upper link may be disposed to be closer to the lower edge of the display panel than one end of the upper link.

In a fully wound state of the display panel, the plurality of links may be disposed to be horizontal to the upper edge of the display panel, the other end of the lower link may be disposed to be farther from a center area of the display panel than the one end of the lower link, and the other end of the upper link may be disposed to be closer to the center area of the display panel than one end of the upper link.

The length from the support shaft to the other end of the lower link may be shorter than the length from the support shaft to the one end of the lower link.

While winding the display panel, the driving unit may rotate the roller with a force smaller than a force of the elastic member which lifts the plurality of links.

While winding the display panel, the driving unit may rotate the one end of the lower link around the support shaft to lower the lower link.

According to another aspect of the present disclosure, there is provided a rollable display device. The rollable display device includes a roller, a display unit fixed to the roller,a plurality of links which supports the display unit to be flat, a driving unit which rotates the roller and a lifting unit which applies a force to the plurality of links. The display unit is wound by the roller which rotates by the driving unit and is unwound by the roller which rotates by the driving unit and the plurality of links which is unfolded by the lifting unit.

Each of the plurality of links may include a lower link having the other end applied with a force from the lifting unit and an upper link whose the other end is rotatably coupled to one end of the lower link to transmit the force from the driving unit to one end of the lower link, and the lower link may rotate around a support shaft. A length from the support shaft to the one end of the lower link may be longer than a length from the support shaft to the other end of the lower link.

While winding the display unit, a force of the driving unit may be smaller than a force of the lifting unit and a torque applied to the one end of the lower link may be larger than a torque applied to the other end of the lower link.

While winding the display unit, the driving unit may apply the force so as to lower the display unit and the lifting unit may apply the force to lift the display unit, and while unwinding the display unit, the driving unit and the lifting unit may apply the force to lift the display unit.

## Claims

1. A display device (100), comprising:
a display panel (DP) having a first edge, and a second edge opposing the first edge;
a roller (111) to which the first edge of the display panel is fixed;
a link assembly (120) having a first end, the first end of the link assembly connected to the second edge of the display panel; **characterized in that**
a driving unit (141) is disposed outside of the roller and directly connected to the roller, wherein the driving unit applies a torque to the roller to rotate the roller and thereby wind the display panel around the roller; and
a lifting unit (150) is disposed outside the roller and connected to a second end of the link assembly, wherein the lifting unit comprises ar elastic member connected to the second end of the link assembly.

2. The display device according to claim 1 wherein the lifting unit is configured to apply a force to the link assembly, thereby extending the link assembly and unwinding the display panel from the roller.

3. The display device according to any preceding claim, wherein the driving unit is connected to at least one end of the roller, and is configured to rotate the roller in a clockwise direction or a counterclockwise direction.

4. The display device according to any preceding claim, wherein the link assembly is connected to the second edge of the display panel by a head bar (130).

5. The display device according to any preceding claim, wherein the link assembly includes:
a first link (121U) at the first end of the link assembly, and a second link (121D) at the second end of the link assembly, wherein the first link and the second link are rotatably coupled to each other by a link connecting unit (122).

6. The display device according to claim 5, wherein the second link is rotatably coupled to a support shaft (124), and the lifting unit is configured to rotate the second link about the support shaft, to thereby lift the link assembly.

7. The display device according to claim 5 or claim 6 wherein a length of the lifting unit in a fully wound state of the display panel is longer than a length of the lifting unit in a fully unwound state of the display panel.

8. The display device according to any of claims 5 to 7 wherein the lifting unit is configured to apply a force which rotates the second link, to thereby lift the link assembly.

9. The display device according to any of claims 7 to 8 wherein in a fully unwound state of the display panel, the first and second links of the link assembly are substantially perpendicular to the second edge of the display panel.

10. The display device according to any of claims 5 to 9 wherein in a fully wound state of the display panel, the first and second links of the link assembly are substantially parallel to the second edge of the display panel, and the link connecting unit is disposed closer to a midpoint along the roller than in a fully unwound state.

11. The display device according to any of claims 5 to 10, wherein a distance from the support shaft to the lifting unit is shorter than a distance from the support shaft to the link connecting unit.

12. The display device according to any preceding claim, wherein while winding the display panel, the driving unit rotates the roller with a force smaller than a force of the lifting unit which extends the link assembly.

13. The display device according to any of claims 5 to 12 wherein the support shaft is arranged such that, while the driving unit is winding the display panel, the second link rotates about the support shaft to lower the link assembly.

## Patentansprüche

1. Anzeigevorrichtung (100), Folgendes umfassend:
eine Anzeigefläche (DP) mit einem ersten Rand und einem dem ersten Rand gegenüberliegenden zweiten Rand,
eine Rolle (111), an welcher der erste Rand der Anzeigefläche befestigt ist,
eine Gestängeanordnung (120) mit einem ersten Ende, wobei das erste Ende der Gestängeanordnung mit dem zweiten Rand der Anzeigefläche verbunden ist,
**dadurch gekennzeichnet, dass**
eine Antriebseinheit (141) außerhalb der Rolle angeordnet und direkt mit der Rolle verbunden ist, wobei die Antriebseinheit ein Drehmoment auf die Rolle ausübt, um die Rolle zu drehen und dadurch die Anzeigefläche auf die Rolle aufzuwickeln, und
eine Hebeeinheit (150), die außerhalb der Rolle angeordnet und mit einem zweiten Ende der Gestängeanordnung verbunden ist, wobei die Hebeeinheit ein elastisches Element umfasst, das mit dem zweiten Ende der Gestängeanordnung verbunden ist.

2. Anzeigevorrichtung nach Anspruch 1, wobei die Hebeeinheit dafür gestaltet ist, eine Kraft auf die Gestängeanordnung auszuüben, wodurch die Gestängeanordnung ausgefahren und die Anzeigefläche von der Rolle abgewickelt wird.

3. Anzeigevorrichtung nach einem der vorhergehenden Ansprüche, wobei die Antriebseinheit mit mindestens einem Ende der Rolle verbunden und dafür gestaltet ist, die Rolle im Uhrzeigersinn oder entgegen dem Uhrzeigersinn zu drehen.

4. Anzeigevorrichtung nach einem der vorhergehenden Ansprüche, wobei die Gestängeanordnung durch eine Kopfleiste (130) mit dem zweiten Rand der Anzeigefläche verbunden ist.

5. Anzeigevorrichtung nach einem der vorhergehenden Ansprüche, wobei die Gestängeanordnung Folgendes beinhaltet:
ein erstes Gestänge (121U) an dem ersten Ende der Gestängeanordnung und ein zweites Gestänge (121D) an dem zweiten Ende der Gestängeanordnung, wobei das erste Gestänge und das zweite Gestänge durch eine Gestängeverbindungseinheit (122) miteinander gekoppelt sind.

6. Anzeigevorrichtung nach Anspruch 5, wobei das zweite Gestänge drehbar mit einer Stützwelle (124) gekoppelt ist und die Hebeeinheit dafür gestaltet ist, das zweite Gestänge um die Stützwelle zu drehen, um dadurch die Gestängeanordnung anzuheben.

7. Anzeigevorrichtung nach Anspruch 5 oder Anspruch 6, wobei eine Länge der Hebeeinheit in einem voll aufgewickelten Zustand der Anzeigefläche länger als eine Länge der Hebeeinheit in einem vollständig abgewickelten Zustand der Anzeigefläche ist.

8. Anzeigevorrichtung nach einem der Ansprüche 5 bis 7, wobei die Hebeeinheit dafür gestaltet ist, eine Kraft auszuüben, die das zweite Gestänge dreht, um dadurch die Gestängeanordnung anzuheben.

9. Anzeigevorrichtung nach einem der Ansprüche 7 bis 8, wobei das erste und das zweite Gestänge der Gestängeanordnung in einem vollständig abgewickelten Zustand der Anzeigefläche im Wesentlichen senkrecht zu dem zweiten Rand der Anzeigefläche liegen.

10. Anzeigevorrichtung nach einem der Ansprüche 5 bis 9, wobei das erste und das zweite Gestänge der Gestängeanordnung in einem vollständig aufgewickelten Zustand der Anzeigefläche im Wesentlichen parallel zu dem zweiten Rand der Anzeigefläche liegen und die Gestängeverbindungseinheit näher an einem Mittelpunkt längs der Rolle angeordnet ist als in einem vollständig abgewickelten Zustand.

11. Anzeigevorrichtung nach einem der Ansprüche 5 bis 10, wobei ein Abstand von der Stützwelle zu der Hebeeinheit kleiner als ein Abstand von der Stützwelle zu der Gestängeverbindungseinheit ist.

12. Anzeigevorrichtung nach einem der vorhergehenden Ansprüche, wobei die Antriebseinheit während des Aufwickelns der Anzeigefläche die Rolle mit einer Kraft dreht, die kleiner als eine Kraft der Hebeeinheit ist, welche die Gestängeanordnung ausfährt.

13. Anzeigevorrichtung nach einem der Ansprüche 5 bis 12, wobei die Stützwelle derart angeordnet ist, dass sich das zweite Gestänge während des Aufwickelns der Anzeigefläche durch die Antriebseinheit um die Stützwelle dreht, um die Gestängeanordnung abzusenken.

## Revendications

1. Dispositif d'affichage (100), comprenant :
un panneau d'affichage (DP) ayant un premier bord, et un deuxième bord opposé au premier bord ;
un rouleau (111) auquel le premier bord du panneau d'affichage est fixé ;
un ensemble de liaison (120) ayant une première extrémité, la première extrémité de l'ensemble de liaison étant raccordée au deuxième bord du panneau d'affichage ; **caractérisé en ce que**
une unité d'entraînement (141) est disposée à l'extérieur du rouleau et directement raccordée au rouleau, l'unité d'entraînement appliquant un couple au rouleau pour faire tourner le rouleau et ainsi enrouler le panneau d'affichage autour du rouleau ; et
une unité de soulèvement (150) est disposée à l'extérieur du rouleau et raccordée à une deuxième extrémité de l'ensemble de liaison, l'unité de levage comprenant un élément élastique raccordé à la deuxième extrémité de l'ensemble de liaison.

2. Dispositif d'affichage selon la revendication 1 dans lequel l'unité de soulèvement est configurée pour appliquer une force à l'ensemble de liaison, étendant ainsi l'ensemble de liaison et déroulant le panneau d'affichage du rouleau.

3. Dispositif d'affichage selon l'une quelconque des revendications précédentes, dans lequel l'unité d'entraînement est raccordée à au moins une extrémité du rouleau, et est configurée pour faire tourner le rouleau dans le sens des aiguilles d'une montre ou dans le sens inverse des aiguilles d'une montre.

4. Dispositif d'affichage selon l'une quelconque des revendications précédentes, dans lequel l'ensemble de liaison est raccordé au deuxième bord du panneau d'affichage par une barre de tête (130).

5. Dispositif d'affichage selon l'une quelconque des revendications précédentes, dans lequel l'ensemble de liaison inclut :
une première liaison (121U) au niveau de la première extrémité de l'ensemble de liaison, et une deuxième liaison (121D) au niveau de la deuxième extrémité de l'ensemble de liaison, la première liaison et la deuxième liaison étant couplées de façon rotative l'une à l'autre par une unité de raccordement de liaison (122) .

6. Dispositif d'affichage selon la revendication 5, dans lequel la deuxième liaison est couplée de façon rotative à un arbre de support (124), et l'unité de soulèvement est configurée pour faire tourner la deuxième liaison autour de l'arbre de support, pour ainsi soulever l'ensemble de liaison.

7. Dispositif d'affichage selon la revendication 5 ou la revendication 6 dans lequel une longueur de l'unité de soulèvement dans un état complètement enroulé du panneau d'affichage est plus longue qu'une longueur de l'unité de soulèvement dans un état complètement déroulé du panneau d'affichage.

8. Dispositif d'affichage selon l'une quelconque des revendications 5 à 7 dans lequel l'unité de soulèvement est configurée pour appliquer une force qui fait tourner la deuxième liaison, pour ainsi soulever l'ensemble de liaison.

9. Dispositif d'affichage selon l'une quelconque des revendications 7 à 8 dans lequel dans un état complètement déroulé du panneau d'affichage, les première et deuxième liaisons de l'ensemble de liaison sont substantiellement perpendiculaires au deuxième bord du panneau d'affichage.

10. Dispositif d'affichage selon l'une quelconque des revendications 5 à 9 dans lequel dans un état complètement enroulé du panneau d'affichage, les première et deuxième liaisons de l'ensemble de liaison sont substantiellement parallèles au deuxième bord du panneau d'affichage, et l'unité de raccordement de liaison est disposée plus près d'un point médian le long du rouleau que dans un état complètement déroulé.

11. Dispositif d'affichage selon l'une quelconque des revendications 5 à 10, dans lequel une distance de l'arbre de support à l'unité de soulèvement est plus courte qu'une distance de l'arbre de support à l'unité de raccordement de liaison.

12. Dispositif d'affichage selon l'une quelconque des revendications précédentes, dans lequel pendant l'enroulement du panneau d'affichage, l'unité d'entraînement fait tourner le rouleau avec une force inférieure à une force de l'unité de soulèvement qui étend l'ensemble de liaison.

13. Dispositif d'affichage selon l'une quelconque des revendications 5 à 12 dans lequel l'arbre de support est agencé de telle sorte que, pendant que l'unité d'entraînement enroule le panneau d'affichage, la deuxième liaison tourne autour de l'arbre de support pour abaisser l'ensemble de liaison.
